# EUROPÄISCHE PATENTSCHRIFT

(11) **EP 2 586 069 B1**
(45) Veröffentlichungstag und Bekanntmachung des Hinweises auf die Patenterteilung: **01.03.2017**
(21) Anmeldenummer: 11723914.5
(22) Anmeldetag: 25.05.2011
(51) Int. Cl.: H01L 33/56, H01L 33/54, H01L 33/58, H01L 33/50, B29D 11/00, G02B 1/04

(54) **VERFAHREN ZUR HERSTELLUNG EINES HALBLEITERBAUELEMENTS**
METHOD FOR PRODUCING A SEMICONDUCTOR COMPONENT
PROCÉDÉ DE FABRICATION D'UN COMPOSANT SEMI-CONDUCTEUR

(30) Priorität: 22.06.2010 DE 102010024545
(43) Veröffentlichungstag der Anmeldung: 01.05.2013
(73) Patentinhaber: OSRAM Opto Semiconductors GmbH, 93055 Regensburg (DE)
(72) Erfinder: KRUPPA, Michael, 85290 Geisenfeld (DE); JEREBIC, Simon, 93105 Tegernheim (DE)
(74) Vertreter: Epping - Hermann - Fischer
(86) Internationale Anmeldenummer: PCT/EP2011/058580
(87) Internationale Veröffentlichungsnummer: WO 2011/160913

(56) Entgegenhaltungen:
- EP-A1- 1 927 636
- EP-A1- 2 030 752
- WO-A2-2005/064626
- WO-A2-2006/089540
- US-A1- 2008 210 965
- US-A1- 2009 065 792
- US-A1- 2010 059 774
- YAN ZHOU ET AL: "One-Component, Low-Temperature, and Fast Cure Epoxy Encapsulant With High Refractive Index for LED Applications", IEEE TRANSACTIONS ON ADVANCED PACKAGING, IEEE SERVICE CENTER, PISCATAWAY, NJ, USA, vol. 31, no. 3, 1 August 2008 (2008-08-01) , pages 484-489, XP011346211, ISSN: 1521-3323, DOI: 10.1109/TADVP.2008.924233

## Beschreibung

Die vorliegende Anmeldung betrifft ein Halbleiterbauelement sowie ein Verfahren zur Herstellung eines Halbleiterbauelements.

Diese Patentanmeldung beansprucht die Priorität der deutschen Patentanmeldung 10 2010 024 545.3.

Zur Steigerung der von strahlungsemittierenden Halbleiterbauelementen wie beispielsweise Leuchtdioden emittierten Strahlungsleistung können Modifikationen an dem Halbleiterchip hinsichtlich seines Schichtaufbaus oder seiner Geometrie vorgenommen werden. Dies ist jedoch aufwändig und kostenintensiv.

WO 2006/089540 A2 (OSRAM OPTO SEMICONDUCTORS GMBH; Veröffentlichungsdatum: 31. August 2006) offenbart ein Verfahren zur Herstellung eines optischen und eines strahlungsemittierenden Bauelements mittels eines Molding-Prozesses.

Eine Aufgabe ist es, ein Halbleiterbauelement anzugeben, bei dem die im Betrieb emittierte Strahlungsleistung erhöht ist. Weiterhin soll ein Verfahren zur Herstellung eines solchen Halbleiterbauelements angegeben werden, mit dem solche Bauelemente vereinfacht und zuverlässig hergestellt werden können.

Diese Aufgabe wird durch ein Herstellungsverfahren gemäß den unabhängigen Patentansprüchen gelöst. Weitere Ausgestaltungen und Zweckmäßigkeiten sind Gegenstand der abhängigen Patentansprüche.

Gemäß einer Ausführungsform weist ein Halbleiterbauelement einen optoelektronischen Halbleiterchip und ein auf einer Strahlungsdurchtrittsfläche des Halbleiterchips angeordnetes optisches Element auf. Das optische Element basiert auf einem hochbrechenden Polymermaterial.

Aufgrund seiner hochbrechenden Eigenschaft kann das optische Element verbessert zur Verringerung von Brechungsindexsprüngen zwischen Halbleiterchip und Umgebung beitragen.

Auf einem hochbrechenden Polymermaterial "basierend" bedeutet in diesem Zusammenhang, dass das hochbrechende Polymermaterial das Grundmaterial für das optische Element bildet. Dem hochbrechenden Polymermaterial als Grundmaterial kann weiteres Material beigemengt sein, beispielsweise Lumineszenzkonversionsmaterial zur Umwandlung von im Halbleiterchip erzeugter Strahlung und/oder Diffusormaterial.

Vorzugsweise enthält das optische Element mit einem Gewichtsanteil von mindestens 80 % hochbrechendes Polymermaterial.

In einer Weiterbildung sind in das hochbrechende Polymermaterial Nanopartikel zur Erhöhung des Brechungsindices vorgesehen. Die Nanopartikel weisen zweckmäßigerweise einen Brechungsindex auf, der größer ist als der Brechungsindex des hochbrechenden Polymermaterials. Die Nanopartikel sind hinsichtlich ihrer mittleren Größe zweckmäßigerweise derart ausgebildet, dass sie die vom Halbleiterbauelement zu erzeugende und/oder zu empfangende Strahlung nicht oder zumindest nicht wesentlich absorbieren. Unter einem hochbrechenden Material wird im Rahmen der Anmeldung ein Material verstanden, das einen Brechungsindex von mindestens 1,50 aufweist.

Vorzugsweise beträgt ein Brechungsindex des optischen Elements, insbesondere das Polymer-Material des optischen Elements, mindestens 1,52, besonders bevorzugt mindestens 1,54. Weiterhin ist der Brechungsindex des optischen Elements zweckmäßigerweise kleiner als ein Brechungsindex des dem optischen Element zugewandten Halbleitermaterials des Halbleiterbauelements.

In einer bevorzugten Ausgestaltung enthält das optische Element ein Silikon, ein Epoxid oder ein Hybridmaterial. Beispielsweise zeichnet sich Diphenylsiloxan durch einen vergleichsweise hohen Brechungsindex von 1,54 aus.

Das optische Element dient der Strahlformung der durch die Strahlungsdurchtrittsfläche des Halbleiterchips hindurchtretenden Strahlung. Die Strahlformung kann hierbei insbesondere die räumliche und/oder die spektrale Abstrahlcharakteristik betreffen.

In einer Ausgestaltung ist das optische Element auf der dem Halbleiterchip abgewandten Seite zumindest bereichsweise gekrümmt, insbesondere in Aufsicht auf das Halbleiterbauelement konvex gekrümmt. Das optische Element kann somit die Funktion einer strahlungsbündelnden Linse erfüllen.

In einer lateralen Richtung erstreckt sich das optische Element vorzugsweise höchstens bis zu einer Seitenfläche des Halbleiterchips, die den Halbleiterchip in lateraler Richtung begrenzt. Das optische Element ragt somit in lateraler Richtung nicht über den Halbleiterchip hinaus. Unter einer lateralen Richtung wird im Zweifel eine Richtung verstanden, die entlang einer Haupterstreckungsebene der Halbleiterschichten des Halbleiterchips verläuft.

Die den Halbleiterchip in lateraler Richtung begrenzende Seitenfläche kann somit frei von dem Material für das optische Element sein.

Nach dem erfindungsgemäßen Herstellungsverfahren grenzt das optische Element, unmittelbar, an den Halbleiterchip an. Insbesondere ist das optische Element bei der Herstellung des Halbleiterbauelements an den Halbleiterchip angeformt.

In einer bevorzugten Weiterbildung ist in das optische Element ein Lumineszenzkonversionsstoff eingebettet. Der Lumineszenzkonversionsstoff ist dafür vorgesehen, die im Betrieb in dem Halbleiterchip erzeugte Strahlung zumindest teilweise zu absorbieren und in Strahlung einer anderen Wellenlänge zu konvertieren.

In einer weiteren bevorzugten Weiterbildung ist auf der dem Halbleiterchip abgewandten Seite des optischen Elements ein weiteres optisches Element angeordnet, das auf einem hochbrechenden Polymermaterial basiert und weiterhin bevorzugt konvex gekrümmt ist.

In diesem Fall können das optische Element der spektralen Strahlformung und das weitere optische Element der räumlichen Strahlformung dienen.

Die zwischen dem Halbleiterchip und dem optischen Element angeordnete Verbindungsschicht ist vorzugsweise hochbrechend ausgebildet. Insbesondere ist der Brechungsindex der Verbindungsschicht vorzugsweise größer oder gleich dem Brechungsindex des angrenzenden optischen Elements. Die Verbindungsschicht kann auf einem hochbrechenden Polymermaterial, etwa einem hochbrechenden Silikon, basieren.

In einer weiteren bevorzugten Ausgestaltung weist das Halbleiterbauelement eine Umhüllung auf, in die der Halbleiterchip eingebettet ist. Vorzugsweise bedeckt die Umhüllung das optische Element zumindest bereichsweise, besonders bevorzugt vollständig. Die Umhüllung grenzt vorzugsweise zumindest bereichsweise unmittelbar an das optische Element an.

Die Umhüllung weist vorzugsweise einen Brechungsindex auf, der kleiner ist als der Brechungsindex des optischen Elements und gegebenenfalls des weiteren optischen Elements.

Weiterhin bevorzugt ist die Umhüllung auf der dem Halbleiterchip abgewandten Seite zumindest bereichsweise linsenförmig ausgebildet. Mittels der Form der Umhüllung ist die räumliche Abstrahlcharakteristik des Halbleiterbauelements einstellbar.

Bei einem Verfahren zur Herstellung eines Halbleiterbauelements wird gemäß einer Ausführungsform ein optoelektronischer Halbleiterchip bereitgestellt. Auf den Halbleiterchip wird eine Formmasse für ein optisches Element aufgebracht, wobei die Formmasse auf einem hochbrechenden Polymermaterial basiert. Die Formmasse wird bei einer Temperatur von höchstens 50° C vorgehärtet. Die Formmasse wird ausgehärtet.

Mittels des vorgelagerten Vorhärtens kann erzielt werden, dass die Formmasse nach dem Vorhärten eine ausreichende Formstabilität aufweist. Das Vorhärten kann insbesondere bei einer Temperatur zwischen einschließlich 10° C und einschließlich 30° C, etwa bei Raumtemperatur erfolgen.

Die Gefahr eines Zerfließens der Formmasse während des Härtungsschritts ist mittels des Vorhärtens verringert. Das Vorhärten erfolgt zweckmäßigerweise derart, dass die Formmasse nicht über eine Seitenfläche des Halbleiterchips verläuft. Eine unerwünschte Änderung der Form des optischen Elements vor dem vollständigen Aushärten der Formmasse und eine damit verbundene Beeinträchtigung der Qualität des optischen Elements kann so weitgehend reduziert werden.

In einer Ausgestaltung wird das Vorhärten
mittels elektromagnetischer Strahlung induziert. Vorzugsweise erfolgt das Vorhärten mittels ultravioletter Strahlung. Es kann aber auch Strahlung in einem anderen Spektralbereich, beispielsweise Mikrowellen-Strahlung, Anwendung finden.

Es hat sich herausgestellt, dass ein strahlungsinduziertes Härten ein schnelleres Gelieren der Formmasse bewirkt. Die Gefahr eines Zerfließens der Formmasse wird hierdurch weitergehend verringert. Bei einem rein thermischen Härten hingegen können hierbei auftretende Temperaturänderung ein Zerfließen bewirken oder fördern.

In einer bevorzugten Ausgestaltung wird die Formmasse beim Vorhärten Strahlung mit einem Energieeintrag zwischen einschließlich 0,2 J/cm² und 2,0 J/cm² ausgesetzt. Dieser Bereich hat sich für die Herstellung eines optischen Elements mit hoher optischer Qualität als besonders geeignet herausgestellt.

Alternativ oder ergänzend kann die Formmasse für das Vorhärten mittels Mischens von zumindest zwei Komponenten der Formmasse aktiviert werden. In diesem Fall kann die Aktivierung der Formmasse intrinsisch, also ohne weitere äußere Einwirkung erfolgen und ein Vorhärten bewirken. Dies kann jedoch, beispielsweise mittels elektromagnetischer Strahlung, zusätzlich ausgelöst oder beschleunigt werden.

In einer weiteren bevorzugten Ausgestaltung wird beim Aushärten der Formmasse ein thermisches Härten durchgeführt.

Das Aushärten erfolgt vorzugsweise bei einer höheren Temperatur als das Vorhärten. Aufgrund des Vorvernetzens der Formmasse beim Vorhärten ist die Gefahr eines thermisch induzierten Zerfließens während des thermischen Härtens auch bei vergleichsweise hohen Temperaturen weitgehend vermindert.

Je höher die Temperatur beim thermischen Härten liegt, desto geringer kann die Dauer des Härteschritts sein. Vorzugsweise beträgt die Temperatur zwischen Raumtemperatur und 200° C, besonders bevorzugt zwischen einschließlich 50° C und einschließlich 150° C.

Die Formmasse kann unmittelbar auf den optoelektronischen Halbleiterchip aufgebracht werden. Alternativ kann vor dem Aufbringen der Formmasse auch eine weitere Schicht oder ein weiteres Element, beispielsweise ein Plättchen, das einen Lumineszenzkonversionsstoff enthält, aufgebracht werden.

Das beschriebene Verfahren eignet sich insbesondere zur Herstellung eines weiter oben beschriebenen Halbleiterbauelements. Im Zusammenhang mit dem Halbleiterbauelement angeführte Merkmale können daher auch für das Verfahren herangezogen werden und umgekehrt.

Weitere Ausgestaltungen und Zweckmäßigkeiten ergeben sich aus der folgenden Beschreibung der Ausführungsbeispiele in Verbindung mit den Figuren.

Es zeigen:
Figur 1 ein erstes Ausführungsbeispiel für ein Halbleiterbauelement in schematischer Schnittansicht;
Figur 2 eine vergrößerte Darstellung eines Halbleiterchips und eines optischen Elements gemäß dem in Figur 1 dargestellten ersten Ausführungsbeispiel;
Figur 3 ein zweites, nicht erfindungsgemäßes, Ausführungsbeispiel für einen Halbleiterchip mit einem optischen Element in schematischer Schnittansicht;
Die Figuren 4A bis 4E Abbildungen von fünf Ausführungsbeispiele für ein optisches Element jeweils in Schnittansicht;
Figur 5 eine Messung der von Halbleiterbauelementen emittierten Strahlungsleistung P (in beliebigen Einheiten) in Abhängigkeit vom Gewicht des optischen Elements in Vielfachen i einer vorgegebenen Materialmenge; und
die Figuren 6A bis 6C ein Ausführungsbeispiel für ein Verfahren zur Herstellung eines Halbleiterbauelements anhand von schematisch in Schnittansicht dargestellten Zwischenschritten.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

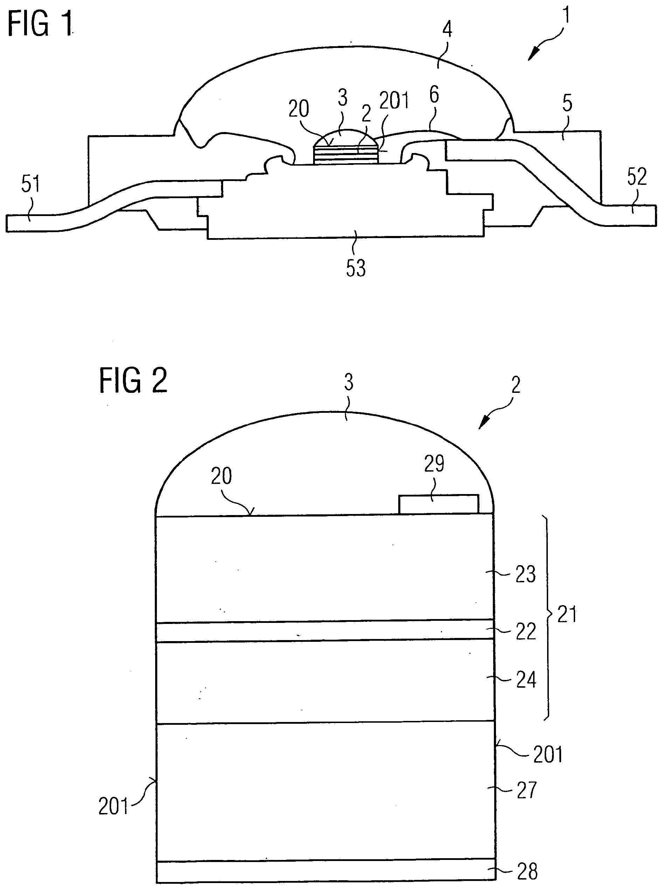

Ein erstes Ausführungsbeispiel für ein Halbleiterbauelement ist in Figur 1 schematisch in Schnittansicht dargestellt. Das Halbleiterbauelement 1 ist exemplarisch als ein oberflächenmontierbares Bauelement (surface mounted device, SMD) ausgeführt, etwa als Lumineszenzdioden-Bauelement.

Das Halbleiterbauelement 1 weist einen optoelektronischen Halbleiterchip 2 und ein optisches Element 3 auf, das auf einer Strahlungsdurchtrittsfläche 20 des Halbleiterchips 2 angeordnet ist.

Das Halbleiterbauelement umfasst weiterhin einen Gehäusekörper 5, der an einen Leiterrahmen mit einem ersten Kontakt 51 und einem zweiten Kontakt 52 angeformt ist. Weiterhin ist in dem Gehäusekörper 5 ein thermischer Kontakt 53 ausgebildet. Im Unterschied zum ersten und zweiten Kontakt dient der thermische Kontakt vorwiegend nicht der elektrischen Kontaktierung, sondern der Abfuhr der im Halbleiterchip im Betrieb erzeugten Abwärme.

Der erste Kontakt 51 und der zweite Kontakt 52 dienen im Betrieb des Halbleiterchips 2 der Injektion von Ladungsträgern in den Halbleiterchip 2, insbesondere in einen zur Erzeugung von Strahlung vorgesehenen aktiven Bereich des Halbleiterchips. Der Halbleiterchip 2 ist über eine Verbindungsleitung 6, beispielsweise einem Bonddraht, elektrisch leitend mit dem zweiten Kontakt verbunden. Die Verbindungsleitung verläuft zumindest bereichsweise außerhalb des optischen Elements 3. Die Verbindungsleitung kann auch vollständig außerhalb des optischen Elements 3 verlaufen.

Das Halbleiterbauelement 1 umfasst weiterhin eine Umhüllung 4. Der Halbleiterchip 2 und gegebenenfalls die Verbindungsleitung 6 ist mittels dieser Umhüllung verkapselt und somit vor äußeren Einflüssen, beispielsweise Feuchtigkeit, Staub oder mechanische Belastungen geschützt.

Weiterhin umformt die Umhüllung das optische Element 3 auf der dem Halbleiterchip 2 abgewandten Seite vollständig.

Die Umhüllung 4 kann beispielsweise ein Epoxid oder ein Silikon oder eine Mischung aus einem Epoxid und einem Silikon enthalten oder aus einem solchen Material bestehen.

Das optische Element 3 basiert auf einem hochbrechenden Polymermaterial und weist vorzugsweise einen Brechungsindex von mindestens 1,52, besonders bevorzugt mindestens 1,54, auf. Insbesondere kann das Polymermaterial einen Brechungsindex von mindestens 1,52, bevorzugt mindestens 1,54, aufweisen. Das Polymermaterial enthält bevorzugt ein hochbrechendes Silikon. Beispielsweise zeichnet sich Diphenylsiloxan durch einen vergleichsweise hohen Brechungsindex von 1,54 aus. Alternativ oder ergänzend kann auch ein anderes Polymermaterial, beispielsweise ein Epoxid oder ein Hybridmaterial, etwa Polyurethan, Anwendung finden.

In dem Polymermaterial können weiterhin zur Steigerung des Brechungsindices Nanopartikel ausgebildet sein, die einen größeren Brechungsindex aufweisen als das Polymermaterial. Der Brechungsindex des optischen Elements kann hierdurch weitergehend gesteigert werden. Zweckmäßigerweise sind die Nanopartikel hinsichtlich ihrer Größe derart ausgebildet, dass sie die im Betrieb des Halbleiterchips erzeugte Strahlung nicht oder zumindest nicht wesentlich absorbieren.

Auf der dem Halbleiterchip 2 abgewandten Seite ist das optische Element in Aufsicht auf das Halbleiterbauelement 1 konvex gekrümmt ausgebildet und dient so der Strahlbündelung der im Halbleiterchip erzeugten Strahlung.

In lateraler Richtung, also entlang einer in einer Haupterstreckungsebene der Halbleiterschichten des Halbleiterkörpers 2 verlaufenden Richtung, erstreckt sich das optische Element 3 nicht über eine den Halbleiterkörper in lateraler Richtung begrenzende Seitenfläche 201 hinaus. Die Seitenfläche 201 ist somit frei von dem Material für das optische Element 3.

Der Halbleiterchip 2 enthält vorzugsweise ein III-V-Verbindungshalbleitermaterial. III-V-Halbleitermaterialien sind zur Strahlungserzeugung im ultravioletten (Alₓ In_{y} Ga_{1-x-y} N) über den sichtbaren (Alₓ In_{y} Ga_{1-x-y} N, insbesondere für blaue bis grüne Strahlung, oder Alₓ In_{y} Ga_{1-x-y} P (phosphidische Verbindungshalbleitermaterialien), insbesondere für gelbe bis rote Strahlung) bis in den infraroten (Alₓ Iny Ga_{1-x-y} As (arsenidische Verbindungshalbleitermaterialien)) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Derartige Halbleitermaterialien, insbesondere phosphidische und arsenidische Verbindungshalbleitermaterialien weisen einen vergleichsweise hohen Brechungsindex auf.

Aufgrund des hohen Brechungsindices des optischen Elements 3 ist der Brechungsindexsprung für durch die Strahlungsdurchtrittsfläche 20 austretende Strahlung im Vergleich zu einem Bauelement ohne ein solches optisches Element verringert. Dadurch reduziert sich derjenige Anteil der Strahlung, der aufgrund von Totalreflexion an der Strahlungsdurchtrittsfläche 20 im Halbleiterkörper verbleibt und nicht ausgekoppelt wird. Für den Fall eines phosphidischen Halbleiterchips 2 hat sich herausgestellt, dass die aus dem Bauelement 1 emittierte Strahlungsleistung mittels des optischen Elements um bis zu 16 % erhöht werden kann.

In Figur 2 sind der Halbleiterchip 2 und das optische Element 3 des im Zusammenhang mit Figur 1 beschriebenen ersten Ausführungsbeispiels in vergrößerter Darstellung gezeigt.

Der Halbleiterchip 2 weist einen Halbleiterkörper 21 mit einer Halbleiterschichtenfolge auf. Die vorzugsweise epitaktisch abgeschiedene Halbleiterschichtenfolge bildet den Halbleiterkörper und umfasst einen zur Erzeugung von Strahlung vorgesehenen aktiven Bereich 22, der zwischen einem ersten Halbleiterbereich 23 eines ersten Leitungstyps und einem zweiten Halbleiterbereich 24 eines vom ersten Leitungstyp verschiedenen zweiten Leitungstyps angeordnet ist. Beispielsweise kann der erste Halbleiterbereich 23 p-leitend und der zweite Halbleiterbereich 24 n-leitend ausgeführt sein oder umgekehrt.

Der Halbleiterkörper 21 ist auf einem Träger 27 angeordnet, wobei der Träger beispielsweise ein Aufwachssubstrat für die Halbleiterschichtenfolge sein kann. Auf der dem Halbleiterkörper 21 abgewandten Seite des Trägers ist eine erste Kontaktschicht 28 ausgebildet. Auf der dem Träger abgewandten Seite 27 des Halbleiterkörpers 21 ist ein zweite Kontaktschicht 29 ausgebildet. Die Kontaktschichten 28, 29 sind für die Injektion von Ladungsträgern von verschiedenen Seiten in den aktiven Bereich 22 vorgesehen.

Das hochbrechende optische Element 3 ist auf der Strahlungsdurchtrittsfläche 20 des Halbleiterchips 2 ausgebildet. Das optische Element bedeckt auch zumindest einen Teil der zweiten Kontaktschicht 29 und weiterhin auch einen Teil der in dieser Figur nicht explizit dargestellten Verbindungsleitung 6.

Von dem beschriebenen Ausführungsbeispiel abweichend können auch beide Kontaktschichten 28, 29 auf derselben Seite des Halbleiterkörpers ausgebildet sein. Beispielsweise kann der Halbleiterchip als ein Flip-Chip ausgebildet sein, so dass der Halbleiterchip auf der Seite des optischen Elements 3 keinen Kontakt aufweist. Auch ein Halbleiterchip, bei dem beide Kontakte auf der dem optischen Element zugewandten Seite angeordnet sind, kann Anwendung finden. In diesem Fall können zwei Verbindungsleitungen zumindest bereichsweise innerhalb des optischen Elements verlaufen.

Ferner eignet sich das beschriebene optische Element 3 auch für einen Halbleiterchip, der als Strahlungsdetektor ausgebildet ist.

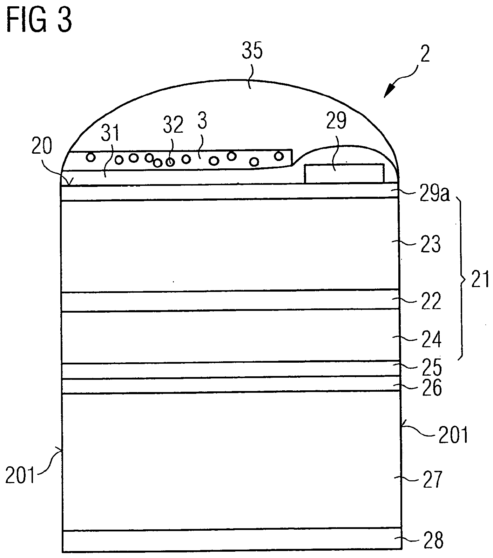

Ein zweites, nicht erfindungsgemäßes, Ausführungsbeispiel für ein Halbleiterbauelement 1 ist in Figur 3 schematisch in Schnittansicht dargestellt. Dieses Ausführungsbeispiel entspricht im Wesentlichen dem im Zusammenhang mit den Figuren 1 und 2 beschriebenen ersten Ausführungsbeispiel. Insbesondere kann der Halbleiterchip 2 wie im Zusammenhang mit Figur 1 beschrieben in einem Gehäusekörper eines oberflächenmontierbaren Bauelements angeordnet sein.

Selbstverständlich kann der Halbleiterchip jedoch ebenso wie der in Figur 2 dargestellte Halbleiterchip auch in einer anderen Gehäuseform, beispielsweise in einem Gehäuse in Radial-Geometrie, angeordnet sein.

Im Unterschied zum ersten Ausführungsbeispiel ist das optische Element 3 als ein Plättchen ausgebildet, in dem ein Lumineszenzkonversionsstoff 32 eingebettet ist.

Zwischen dem optischen Element 3 und dem Halbleiterchip 2 ist eine Verbindungsschicht 31 angeordnet, mit der das optische Element 3 an dem Halbleiterchip befestigt ist. Das optische Element ist in diesem Ausführungsbeispiel also bereits vorgefertigt.

Die Verbindungsschicht 31 ist vorzugsweise ebenfalls hochbrechend ausgeführt. Besonders bevorzugt ist der Brechungsindex der Verbindungsschicht 31 größer als oder gleich dem Brechungsindex des optischen Elements 3. Weiterhin bevorzugt basiert die Verbindungsschicht 31 auf einem hochbrechenden Polymermaterial, beispielsweise einem hochbrechenden Silikon.

Auf der dem Halbleiterchip 2 abgewandten Seite des optischen Elements 3 ist ein weiteres optisches Element 35 ausgebildet. Das weitere optische Element 35 basiert vorzugsweise ebenfalls auf einem hochbrechenden Polymermaterial, etwa Silikon und dient der Strahlformung der aus dem Halbleiterchip 2 austretenden Strahlung.

Mittels der Verbindungsschicht 31 und des optischen Elements 3 ist ein Brechungsindexsprung für die aus dem Halbleiterchip 2 austretende Strahlung verringert, so dass die aus dem Halbleiterchip austretende Strahlungsleistung gesteigert werden kann. Das weitere optische Element 35 dient einer weiteren Erhöhung der Strahlungsauskopplung und der räumlichen Strahlformung. Auf das weitere optische Element 35 kann jedoch auch verzichtet werden.

Der Lumineszenzkonversionsstoff 32 in dem optischen Element 3 ist für die zumindest teilweise Konversion von im aktiven Bereich 22 des Halbleiterkörpers 21 im Betrieb erzeugter Strahlung vorgesehen.

Das beschriebene optische Element 3 mit der Verbindungsschicht 31 kann auch bei dem im Zusammenhang mit Figur 2 beschriebenen ersten Ausführungsbeispiel für einen Halbleiterchip Anwendung finden.

Im Unterschied zu dem in der Figur 2 dargestellten Halbleiterchip weist der Halbleiterchip gemäß dem in Figur 3 dargestellten zweiten, nicht erfindungsgemäßen, Ausführungsbeispiel einen Träger 27 auf, der von einem Aufwachssubstrat für die Halbleiterschichtenfolge des Halbleiterkörpers 21 verschieden ist. Der Träger 27 kann beispielsweise ein Halbleitermaterial, etwa Silizium, Galliumarsenid oder Germanium, oder eine Keramik, etwa Aluminiumnitrid oder Bornitrid, enthalten oder aus einem solchen Material bestehen. Der Halbleiterkörper 21 ist mittels einer Montageschicht 26 an dem Träger befestigt. Beispielsweise eignet sich für die Montageschicht eine Klebeschicht oder eine Lotschicht.

Der Träger 27 stabilisiert den Halbleiterkörper 21 mechanisch. Das Aufwachssubstrat ist hierfür nicht mehr erforderlich und kann zumindest bereichsweise oder vollständig gedünnt oder entfernt sein. Ein Halbleiterchip, bei dem das Aufwachssubstrat entfernt ist, wird auch als Dünnfilm-Halbleiterchip bezeichnet.

Auf der der Strahlungsdurchtrittsfläche 20 des Halbleiterchips abgewandten Seite weist der Halbleiterkörper 21 eine Spiegelschicht 25 auf, die in Richtung des Trägers 27 abgestrahlte Strahlung zur Strahlungsdurchtrittsfläche hin reflektiert. Die Spiegelschicht 25 ist zweckmäßigerweise für die im aktiven Bereich 22 erzeugte Strahlung hochreflektierend ausgebildet und weist weiterhin eine vom Auftreffwinkel der Strahlung weitgehend unabhängige hohe Reflektivität auf. Die Spiegelschicht enthält vorzugsweise ein Metall, beispielsweise Silber, Rhodium, Aluminium oder Chrom oder eine metallische Legierung mit zumindest einem der genannten Materialien.

Weiterhin ist zwischen dem Halbleiterkörper 21 und der zweiten Kontaktschicht 29 eine Verteilungsschicht 29a ausgebildet. Die Verteilungsschicht 29a ist für eine in lateraler Richtung gleichmäßige Injektion von Ladungsträgern über den ersten Halbleiterbereich 23 in den aktiven Bereich 22 vorgesehen.

Bei einer ausreichend hohen Querleitfähigkeit des ersten Halbleiterbereichs 23 kann auf die Verteilungsschicht 29a aber auch verzichtet werden.

Die Verteilungsschicht 29a ist zweckmäßigerweise für die im aktiven Bereich 22 erzeugte Strahlung transparent oder zumindest transluzent ausgebildet. Beispielsweise kann die Verteilungsschicht 29a ein transparentes leitfähiges Oxid (transparent conductive oxide, TCO), etwa Indiumzinnoxid (ITO) oder Zinkoxid (ZnO) enthalten. Alternativ oder ergänzend kann auch eine Metallschicht Anwendung finden, die so dünn ist, dass die Strahlung zumindest teilweise hindurch treten kann.

Der Halbeiterkörper 21, insbesondere der aktive Bereich 22, kann beispielsweise auf einem nitridischen Halbleitermaterial basieren und zur Erzeugung von blauer oder ultravioletter Strahlung vorgesehen sein. Zusammen mit der in dem optischen Element 3 mittels des Lumineszenzkonversionsstoffs 32 konvertierten Strahlung kann somit eine integrierte Mischlichtquelle, beispielsweise eine Weißlichtquelle, ausgebildet sein. Für ein Bauelement mit einem solchen Halbleiterchip wurde eine Erhöhung der Strahlungsleistung aufgrund des optischen Elements 3 von etwa 5 % beobachtet.

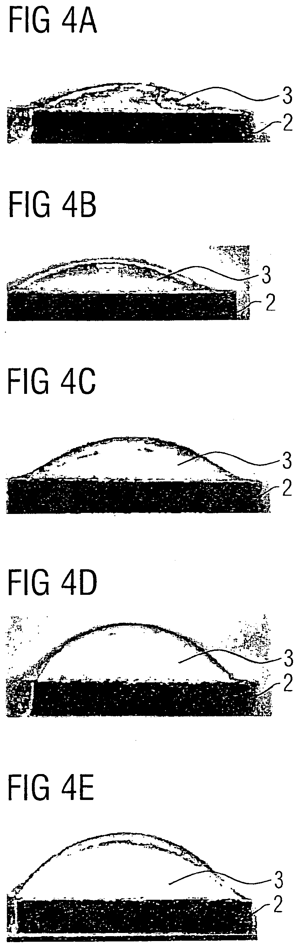

In den Figuren 4A bis 4E sind verschiedene Ausführungsbeispiele für ein optisches Element 3 auf einem Halbleiterchip 2 gezeigt. Die optischen Elemente unterscheiden sich durch die bei der Herstellung verwendete Materialmenge. Die verwendete Materialmenge beträgt in den Figuren vier Mengeneinheiten (Figur 4A), fünf Mengeneinheiten (Figur 4B), sieben Mengeneinheiten (Figur 4C), zehn Mengeneinheiten (Figur 4D) und 13 Mengeneinheiten (Figur 4E).

Die Figuren zeigen, dass sich mit zunehmender Materialmenge die Höhe des optischen Elements 3, also die Ausdehnung senkrecht zum Halbleiterchip, steigern lässt. Die Höhe beträgt in diesen Ausführungsbeispielen 157 µm, 175 µm, 241 µm, 301 µm beziehungsweise 365 µm.

Die Figuren zeigen weiterhin, dass die bei der Herstellung verwendete Formmasse für das optische Element 3 vollständig auf der Strahlungsdurchtrittsfläche des Halbleiterchips 2 verbleibt und nicht über die Seitenflächen des Halbleiterchips hinaus verläuft. Somit lassen sich optische Elemente realisieren, deren dem Halbleiterchip abgewandte Seite nahe an eine Form mit sphärischer Krümmung herankommt.

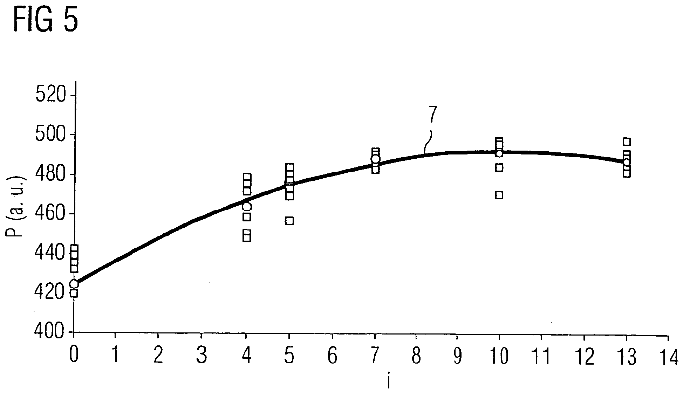

Der Einfluss der Größe des optischen Elements 3 für die in den Figuren 4A bis 4E dargestellten Ausführungsbeispiele ist in Figur 5 dargestellt, wobei die emittierte Strahlungsleistung P in beliebigen Einheiten als Funktion der verwendeten Materialmenge in Vielfachen i einer vorgegebenen Mengeneinheit dargestellt ist.

Die Messwerte für i = 0 stellen eine Referenzmessung für ein baugleiches Bauelement ohne ein hochbrechendes optisches Element dar.

Die Kurve 7 stellt eine polynomiale Anpassung an die Messwerte dar. Die Messungen zeigen, dass die Strahlungsleistung P zunächst mit der Zunahme der Größe des optischen Elements 3 ansteigt. Ein Maximum der Strahlungsleistung wird für i = 10 erreicht, wobei die Leistungskurve ein vergleichsweise flaches Maximum aufweist. Im Bereich i = 7 bis i = 13 werden somit ähnlich hohe Ausgangsleistungen erzielt. Je größer die Zahl der Mengeneinheiten i ist, desto stärker nähert sich die Form des optischen Elements an eine sphärisch gekrümmte Kurvenform an. Allerdings erhöht sich mit zunehmender Zahl von Mengeneinheiten die benötigte Materialmenge, was zu höheren Herstellungskosten führt.

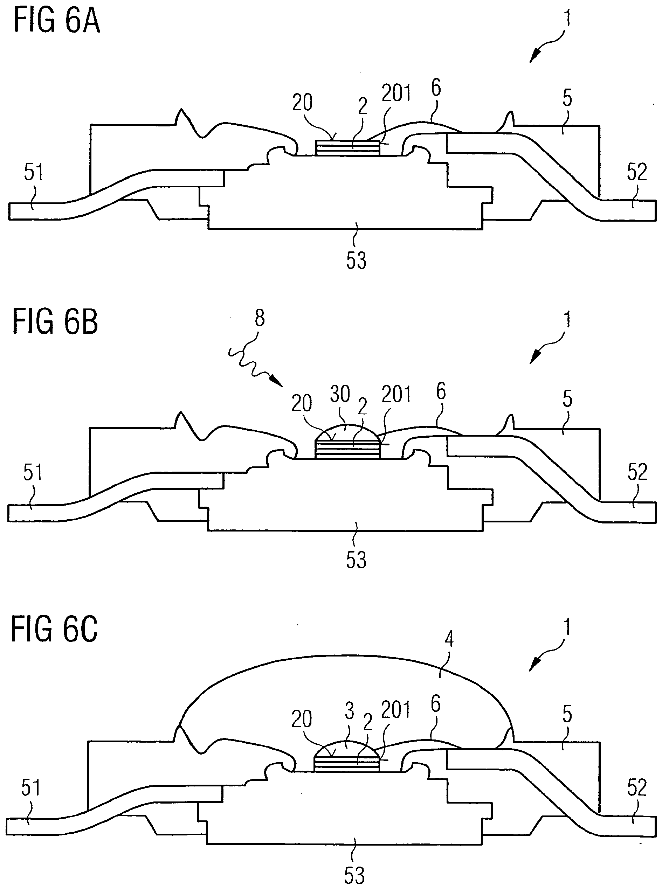

Ein Ausführungsbeispiel für ein Verfahren zur Herstellung eines Halbleiterbauelements ist in den Figuren 6A bis 6C anhand von schematisch in Schnittansicht dargestellten Zwischenschritten gezeigt. Das Verfahren wird lediglich exemplarisch zur Herstellung eines Halbleiterbauelements gemäß dem in Zusammenhang mit den Figuren 1 und 2 beschriebenen ersten Ausführungsbeispiel dargestellt.

Wie in Figur 6A dargestellt, wird ein optoelektronischer Halbleiterchip bereitgestellt. Der optoelektronische Halbleiterchip kann insbesondere bereits auf einem Anschlussträger oder in einem Gehäuse für ein oberflächenmontierbares Bauelement befestigt sein.

Auf den Halbleiterchip 2 wird eine Formmasse 30 für ein optisches Element aufgebracht, wobei die Formmasse auf einem hochbrechenden Silikon basiert. Die Formmasse wird bei einer Temperatur von höchstens 50° C, vorzugsweise bei einer Temperatur zwischen einschließlich 10° C und einschließlich 30° C, vorgehärtet. Das Vorhärten erfolgt in diesem Ausführungsbeispiel mittels elektromagnetischer Strahlung, insbesondere Strahlung im ultravioletten Spektralbereich. Durch das Vorhärten bei vergleichsweise niedrigen Temperaturen erfährt die Formmasse eine derartige Vorvernetzung, dass die Formmasse eine zumindest temporär ausreichende Formstabilität erhält.

Die Formmasse ist weiterhin bevorzugt selbsthaftend ausgebildet. Ein zuverlässiges Aufbringen der Formmasse ist dadurch vereinfacht.

Nachfolgend erfolgt ein Aushärten der Formmasse. Das Aushärten kann beispielsweise als thermisches Härten erfolgen, wobei die Temperatur vorzugsweise höher ist als die Temperatur beim Vorhärten. Thermisches Härten kann bereits bei Raumtemperatur eintreten. Je höher die Temperatur ist, desto schneller findet der Härtungsprozess statt. Insbesondere ab einer Temperatur von 50° C wird der Härtungsprozess signifikant beschleunigt. Die Temperatur beträgt vorzugsweise zwischen einschließlich 50° C und einschließlich 150° C. In diesem Aushärtschritt können die Eigenschaften des herzustellenden optischen Elements eingestellt werden, beispielsweise der Vernetzungsgrad, die Elastizität und/oder die Härte des optischen Elements.

Im Unterschied zu einer rein thermischen Aushärtung bewirkt das dem Aushärten vorgelagerte Vorhärten mittels elektromagnetischer Strahlung kein Zerfließen oder zumindest ein stark reduziertes Zerfließen der Formmasse 30, so dass optische Elemente hoher Qualität mit einer hohen Reproduzierbarkeit hergestellt werden können. Die geometrische Formgebung des optischen Elements 3 kann in weiten Grenzen variiert werden. Insbesondere können optische Elemente hergestellt werden, die ein hohes Aspektverhältnisse, also ein hohes Verhältnis von Höhe zu Breite aufweisen.

Der Energieeintrag der Strahlung beträgt beim Vorhärten vorzugsweise zwischen einschließlich 0,2 J/cm² und einschließlich 2,0 J/cm².

Der Eintrag der elektromagnetischen Strahlung im ultravioletten Spektralbereich ist in Figur 6B mittels eines Pfeils 8 veranschaulicht. Alternativ kann aber auch Strahlung in einem anderen Spektralbereich Anwendung finden, beispielsweise Mikrowellenstrahlung.

Von dem beschriebenen Ausführungsbeispiel abweichend kann das Vorhärten auch durch ein Mischen von zumindest zwei Komponenten der Formmasse 30 induziert werden. In diesem Fall kann das Vorhärten also ohne einen weiteren externen Impuls induziert werden.

Weiterhin kann anstelle des hochbrechenden Silikons auch ein anderes hochbrechendes Polymermaterial Anwendung finden, beispielsweise ein Epoxid oder ein Hybridmaterial.

Die Formmasse 30 wird in diesem Ausführungsbeispiel aufgebracht, nachdem der Halbleiterchip 2 bereits mittels der Verbindungsleitung 6 elektrisch kontaktiert ist. Die Formmasse 30 umformt also auch einen Teil der Verbindungsleitung 6.

Mit dem beschriebenen Verfahren können Halbleiterbauelemente mit optischen Elementen hergestellt werden, die aufgrund ihres hohen Brechungsindices eine Steigerung der Auskoppeleffizienz aus dem Halbleiterchip bewirken und gleichzeitig hinsichtlich ihrer Form besonders zuverlässig hergestellt werden können, ohne dass das Material für das optische Element über die Seitenfläche des Halbleiterchips 2 verläuft.

Somit kann zusätzlich zur Erhöhung der insgesamt aus dem Halbleiterchip austretenden Strahlungsleistung auch eine zuverlässig und reproduzierbar einstellbare geometrische Strahlformung erzielt werden.

Insbesondere zeichnet sich das Verfahren nicht nur beim Aufbringen der Formmasse 30 unmittelbar auf Halbleitermaterial, sondern auch auf mit herkömmlichen Verfahren nur schwer mit einem optischen Element zu versehenden Oberflächen, beispielsweise auf einer Silikonschicht, durch eine hohe Zuverlässigkeit aus.

## Patentansprüche

1. Verfahren zur Herstellung eines Halbleiterbauelements (1) mit den Schritten:
a) Bereitstellen eines optoelektronischen Halbleiterchips (2);
b) Aufbringen einer Formmasse (30) für ein optisches Element (3) unmittelbar auf den Halbleiterchip, wobei eine Seitenfläche (201) des Halbleiterchips frei von der Formmasse bleibt und die Formmasse auf einem hochbrechenden Polymermaterial basiert;
c) Vorhärten der Formmasse bei einer Temperatur von höchstens 50° C nach dem Aufbringen der Formmasse auf den Halbleiterchip derart, dass die Formmasse nicht über die Seitenfläche verläuft; wobei
- das Vorhärten mittels elektromagnetischer Strahlung induziert wird, oder
- bei dem die Formmasse in Schritt c) mittels Mischens von zumindest zwei Komponenten der Formmasse aktiviert wird, und d) Aushärten der Formmasse.

2. Verfahren nach Anspruch 1,
bei dem die Formmasse in Schritt c) Strahlung mit einem Energieeintrag zwischen einschließlich 0,2 J/cm² und
2,0 J/cm² ausgesetzt wird.

3. Verfahren nach einem der vorhergehenden Ansprüche,
bei dem Schritt d) bei einer höheren Temperatur durchgeführt wird als Schritt c).

4. Verfahren nach einem der vorhergehenden Ansprüche,
bei dem in Schritt d) ein thermisches Härten durchgeführt wird.

5. Verfahren nach einem der vorhergehenden Ansprüche,
wobei das hochbrechende Polymermaterial einen Brechungsindex von mindestens 1,52 aufweist.

6. Verfahren nach einem der vorhergehenden Ansprüche,
wobei das optische Element ein Silikon, ein Epoxid oder ein Hybridmaterial enthält.

7. Verfahren nach einem der vorhergehenden Ansprüche,
wobei in das hochbrechende Polymermaterial Nanopartikel zur Erhöhung des Brechungsindices eingebettet sind.

8. Verfahren nach einem der vorhergehenden Ansprüche,
wobei das optische Element auf der dem Halbleiterchip abgewandten Seite in Aufsicht auf das Halbleiterbauelement konvex gekrümmt ist.

9. Verfahren nach einem der vorhergehenden Ansprüche, wobei sich das optische Element in einer lateralen Richtung
höchstens bis zu einer Seitenfläche (201) des Halbleiterchips erstreckt.

10. Verfahren nach einem der vorhergehenden Ansprüche, wobei in das optische Element ein Lumineszenzkonversionsstoff (32) eingebettet ist.

11. Verfahren nach einem der vorhergehenden Ansprüche, wobei in das optische Element ein Lumineszenzkonversionsstoff (32) eingebettet ist und auf der dem Halbleiterchip abgewandten Seite des optischen Elements ein weiteres optisches Element (35) angeordnet ist, das auf einem hochbrechenden Polymermaterial basiert und konvex gekrümmt ist.

## Claims

1. Method for producing a semiconductor component (1) comprising the following steps:
a) providing an optoelectronic semiconductor chip (2) ;
b) applying a moulding compound (30) for an optical element (3) directly to the semiconductor chip, wherein a side area (201) of the semiconductor chip remains free of the moulding compound and the moulding compound is based on a highly refractive polymer material;
c) precuring the moulding compound at a temperature of at most 50°C after the application of the moulding compound to the semiconductor chip such that the moulding compound does not run over the side area; wherein
- the precuring is induced by means of electromagnetic radiation, or
- in which the moulding compound is activated in step c) by means of mixing of at least two components of the moulding compound, and
d) curing the moulding compound.

2. Method according to Claim 1,
wherein the moulding compound is exposed to radiation with an energy input of between 0.2 J/cm² and 2.0 J/cm² inclusive in step c).

3. Method according to either of the preceding claims,
wherein the step d) is carried out at a higher temperature than step c).

4. Method according to any of the preceding claims,
wherein thermal curing is carried out in step d).

5. Method according to any of the preceding claims, wherein the highly refractive polymer material has a refractive index of at least 1.52.

6. Method according to any of the preceding claims, wherein the optical element contains a silicone, an epoxide or a hybrid material.

7. Method according to any of the preceding claims, wherein nanoparticles for increasing the refractive index are embedded into the highly refractive polymer material.

8. Method according to any of the preceding claims, wherein the optical element is convexly curved on the side facing away from the semiconductor chip in a plan view of the semiconductor component.

9. Method according to any of the preceding claims, wherein the optical element extends in a lateral direction at most as far as a side area (201) of the semiconductor chip.

10. Method according to any of the preceding claims, wherein a luminescence conversion substance (32) is embedded into the optical element.

11. Method according to any of the preceding claims, wherein a luminescence conversion substance (32) is embedded into the optical element and a further optical element (35) is arranged on that side of the optical element which faces away from the semiconductor chip, said further optical element being based on a highly refractive polymer material and being convexly curved.

## Revendications

1. Procédé de fabrication d'un composant semi-conducteur (1), comprenant les étapes consistant à :
a) fournir une puce semi-conductrice (2) optoélectronique ;
b) appliquer une masse de moulage (30) destinée à un élément optique (3) directement sur la puce semi-conductrice, dans lequel une surface latérale (201) de la puce semi-conductrice reste dépourvue de la masse de moulage et la masse de moulage est à base d'un matériau polymère à fort indice de réfraction ;
c) durcir préalablement la masse de moulage à une température d'au plus 50°C après l'application de la masse de moulage sur la puce semi-conductrice de manière à ce que la masse de moulage ne se répande pas sur la surface latérale ; dans lequel
- le durcissement préalable est induit par un rayonnement électromagnétique, ou
- dans lequel la masse de moulage est activée lors de l'étape c) par mélange d'au moins deux constituants de la masse de moulage, et
d) durcir la masse de moulage.

2. Procédé selon la revendication 1,
dans lequel la masse de moulage est exposée, lors de l'étape c), à un rayonnement ayant un apport d'énergie compris entre 0,2 J/cm² et 2,0 J/cm² inclus.

3. Procédé selon l'une quelconque des revendications précédentes,
dans lequel l'étape d) est effectuée à une température supérieure à l'étape c).

4. Procédé selon l'une quelconque des revendications précédentes,
dans lequel, lors de l'étape d), un durcissement thermique est effectué.

5. Procédé selon l'une quelconque des revendications précédentes, dans lequel le matériau polymère à fort indice de réfraction présente un indice de réfraction d'au moins 1,52.

6. Procédé selon l'une quelconque des revendications précédentes, dans lequel l'élément optique contient une silicone, un époxyde, ou un matériau hybride.

7. Procédé selon l'une quelconque des revendications précédentes, dans lequel des nanoparticules sont incorporées au matériau polymère à fort indice de réfraction pour augmenter l'indice de réfraction.

8. Procédé selon l'une quelconque des revendications précédentes, dans lequel l'élément optique est incurvé de manière convexe sur la face tournée en sens opposé à la puce semi-conductrice dans une vue de dessus du composant semi-conducteur.

9. Procédé selon l'une quelconque des revendications précédentes, dans lequel l'élément optique s'étend au maximum dans une direction latérale, jusqu'à une surface latérale (201) de la puce semi-conductrice.

10. Procédé selon l'une quelconque des revendications précédentes, dans lequel un matériau de conversion de luminescence (32) est incorporé à l'élément optique.

11. Procédé selon l'une quelconque des revendications précédentes, dans lequel un matériau de conversion de luminescence (32) est incorporé à l'élément optique et un autre élément optique (35) qui est à base de matériau polymère à fort indice de réfraction et est incurvé de manière convexe est disposé sur la face de l'élément optique qui est tournée en sens opposé à la puce semi-conductrice.
